# EUROPEAN PATENT SPECIFICATION

(11) **EP 0 341 034 B1**
(45) Date of publication and mention of the grant of the patent: **24.11.1993**
(21) Application number: 89304433.9
(22) Date of filing: 03.05.1989
(51) Int. Cl.: H01L 33/00, H01S 3/19, H01L 21/78

(54) **A method for the production of semiconductor devices**
Herstellungsverfahren von Halbleitervorrichtungen
Méthode de production de dispositifs à semi-conducteur

(30) Priority: 06.05.1988 JP 110964/88
(43) Date of publication of application: 08.11.1989
(73) Proprietor: SHARP KABUSHIKI KAISHA, Osaka 545 (JP)
(72) Inventor: Hosoda, Masahiro, Kitakatsuragi-gun Nara-ken (JP); Kondo, Masafumi, Nara-shi Nara-ken (JP); Suyama, Takahiro, Tenri-shi Nara-ken (JP); Sasaki, Kazuaki, Yao-shi Osaka (JP); Takahashi, Kosei, Nara-shi Nara-ken (JP); Hayakawa, Toshiro, Yokohama-shi Kanagawa-ken (JP)
(74) Representative: White, Martin David

(56) References cited:
- EP-A- 0 108 475
- FR-A- 2 438 914
- JOURNAL OF APPLIED PHYSICS. vol. 56, no. 5, 01 September 1984, NEW YORK US pages 1298 - 1300; H.Shtrikman et al.: "Be-implanted GaAs/GaAlAs double heterostructure stripe geometry lasers grown by metalorganic chemical vapor deposition"
- PATENT ABSTRACTS OF JAPAN vol. 9, no. 106 (E-313)(1829) 10 May 1985, & Jp-A-59 232475
- JAPANESE JOURNAL OF APPLIED PHYSICS. vol. 26, no. 4, April 1987, TOKYO JP pages L302 - L305; T.Hayakawa et al.: "Reduction in threshold current density of quantum well lasers grown by molecular beam epitaxy on 0.5 degrees misoriented (111)B substrates."

## Description

### BACKGROUND OF THE INVENTION

### 1. Field of the invention:

This invention relates to a method for the production of semiconductor devices, and more particularly, it relates to a method for the production of semiconductor devices by dividing a semiconductor wafer in which the semiconductor devices are formed on a semiconductor substrate, the growth plane of which is substantially the (111) plane.

### 2. Description of the prior art:

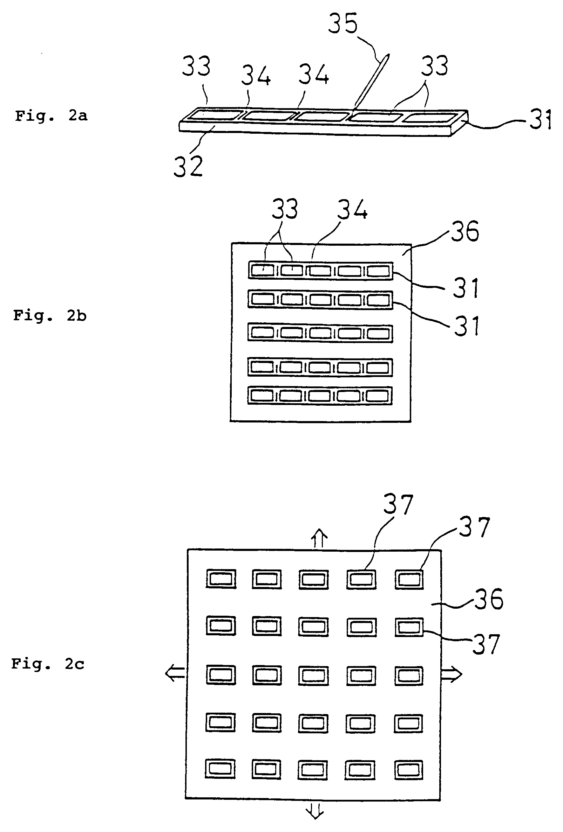

In general, various semiconductor laser devices, which are included in semiconductor devices, have a resonator structure that is formed with the use of cleavage planes of the semiconductor crystal used as a substrate. Such semiconductor laser devices are usually produced according to the process as shown in Figures 2a to 2c.

First, a multi-layered structure comprising a plurality of epitaxial layers is grown on the (100) plane of a substrate that is made of a zinc blende-type semiconductor crystal.

The resulting semiconductor wafer, in which the semiconductor laser devices are formed on the substrate, is cleaved in several small bars **31**. Then, as shown in Figure 2a, the small bar **31** is provided with partition patterns **33** on the upper surface thereof and parallel scratches **34** are formed between the adjacent partition patterns **33** by means of a diamond scriber **35**. The direction of these scratches **34** is normal to the cleavage plane **32** of the small bar **31**.

Next, as shown in Figure 2b, a plurality of the small bars **31** are attached to the upper surface of an adhesive sheet **36** parallel to each other. Then, as shown in Figure 2c, the adhesive sheet **36** is stretched in longitudinal and transverse directions with the application of even force. The strength against the stretch of the portions containing the scratch **34** formed on the upper face of the small bar **31** is lower than of other portions and the direction of the scratch **34** corresponds to that of easy cleavage of the semiconductor substrate. Therefore, when the adhesive sheet **36** is stretched in longitudinal and transverse directions, each small bar **31** is readily divided at each portion containing the scratch **34** to separate semiconductor laser devices **37**.

By this process, conventional semiconductor laser devices are produced from a semiconductor wafer in which a multi-layered structure comprising a plurality of epitaxial layers are grown on a substrate made of a zinc blende-type semiconductor crystal, the growth plane of said substrate being substantially the (100) plane. Thus, the 〈011〉 direction of easy cleavage of the semiconductor substrate is always normal to the cleavage plane **32** of the small bar **31**, so that if scratches **34** are formed in the direction of easy cleavage that is normal to the cleavage plane **32**, the small bar **31** can readily be divided in the same way as mentioned above, resulting in the semiconductor laser devices **37** separated in a rectangular shape.

On the other hand, it is disclosed that semiconductor laser devices formed on the (111) plane of a semiconductor substrate have excellent device characteristics which are significantly improved as compared with conventional semiconductor laser devices (see, for example, T. Hayakawa et al., Japanese Journal of Applied Physics, vol. 26, L302 (1987); U.S. Patent Application Serial Nos. 159,797 and 031,678).

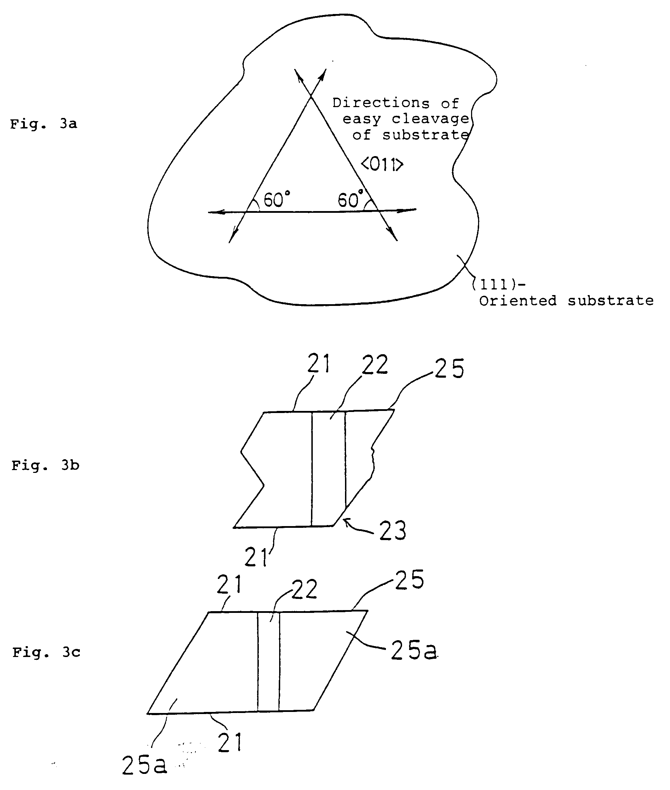

However, the 〈011〉 directions of easy cleavage of the semiconductor substrate, the growth plane of which is the (111) plane, intersect each other at the angle of 60 degrees as shown in Figure 3a. When the semiconductor wafer produced using such a semiconductor substrate is divided into chips, if the facets **21** for the emission of laser light correspond to the (011) cleavage planes, the direction of scratches formed by means of a diamond scriber does not correspond to that of easy cleavage of the semiconductor substrate. That is, the direction of the scratches intersects the direction of easy cleavage. As a result, small bars are divided into semiconductor laser devices **25** with extremely irregular shapes as shown in Figure 3b. In such a case, there may be incurred structural damage **23** in the optical waveguide **22** of the semiconductor laser device **25**. Moreover, there is the danger of wafer dust, which is produced in dividing the semiconductor wafer, adhering to the facets for the emission of laser light, which may degrade the device characteristics. For example, the radiation characteristics of the resulting semiconductor laser device may be distorted.

When the direction of the scratches formed on the small bars corresponds to that of easy cleavage, the semiconductor laser devices 25 are produced in the form of parallelograms, as shown in Figure 3c, or trapezoids. In such a case, unnecessary portions 25a having large areas may be formed in the semiconductor laser device 25, which decreases the number of devices that can be made from any given wafer.

FR-A-2 438 914, on which the preamble of claim 1 is based, discloses a method for the production of semiconductor devices, said method comprising the steps of:- growing a multi-layered structure comprising a plurality of epitaxial layers on a front face of a semiconductor substrate, resulting in a semiconductor wafer in which semiconductor devices are formed on the substrate; forming striped grooves on a back face of said substrate, each of said striped grooves being positioned between adjacent semiconductor devices; and dividing said semiconductor wafer along said striped grooves to separate the semiconductor devices.

In the method disclosed in FR-A-2 438 914, the semiconductor devices are grown on the (100) surface of the substrate, and the striped grooves extend parallel to the (110) direction - that is, parallel to cleavage planes of the substrate.

Journal of Applied Physics Vol. 56(5) (1984), pp 1298-1300 discloses a Be implanted GaAlAs stripe geometry laser grown by MOCVD on the (100) surface of a substrate. Individual lasers are separated from the bulk wafer by an undisclosed process of "chemical etching".

Patent Abstract of Japan, Vol 9, No. 106 (E-313) (1829) 10 May 1985 discloses a method for separating semiconductor lasers from a bulk wafer. Grooves are formed along a back surface of the substrate. A force is applied to one end of the wafer to cleave the substrate along the grooves, and separate the wafer into strips

### SUMMARY OF THE INVENTION

According to the present invention there is provided a method for the production of semiconductor devices, said method comprising the steps of:- growing a multi-layered structure comprising a plurality of epitaxial layers on a front face of a semiconductor substrate, resulting in a semiconductor wafer in which semiconductor devices are formed on the substrate; forming striped grooves on a back face of said substrate, each of said striped grooves being positioned between adjacent semiconductor devices; and dividing said semiconductor wafer along said striped grooves to separate the semiconductor devices; said method being characterised in that said semiconductor substrate is made of a zinc blende-type semiconductor crystal, the growth plane of which is substantially the (111) plane; and in that said striped grooves are formed in a direction which is not parallel to a plane of easy cleavage of said substrate.

In a preferred embodiment, the striped grooves are formed by an etching technique.

In a preferred embodiment, the multi-layered structure comprises an optical waveguide to form a semiconductor laser device.

In a preferred embodiment, the striped grooves are formed parallel to the optical waveguide.

Thus, the invention described herein makes possible the objective of providing a method for the production of semiconductor devices, in which even when the direction of easy cleavage of the semiconductor substrate used intersects the direction of division of the resulting semiconductor wafer (e.g., even when a semiconductor substrate, the growth plane of which is substantially the (111) plane, is used to form the semiconductor wafer), high-quality semiconductor devices can be produced in a uniform rectangular shape without incurring structural damage and without degrading the device characteristics with wafer dust, thereby attaining high productivity.

### BRIEF DESCRIPTION OF THE DRAWINGS

This invention may be better understood and its numerous objects and advantages will become apparent to those skilled in the art by reference to the accompanying drawings as follows:
Figure 1a is a perspective view showing a fragment of a semiconductor wafer in which semiconductor laser devices are formed on a semiconductor wafer according to this invention.
Figure 1b is a plane view showing a fragment of the back face of the semiconductor wafer of Figure 1a.
Figure 1c is a schematic perspective view showing a small bar with striped grooves which is obtained by cleaving the semiconductor wafer of Figure 1b along its cleavage planes.
Figure 2a is a schematic perspective view showing a conventional small bar without striped grooves.
Figure 2b is a top plane view showing the small bars as shown in Figure 2a, which are attached to the upper surface of an adhesive sheet.
Figure 2c is a top plane view showing semiconductor laser devices separated from each other by stretching the adhesive sheet of Figure 2b.
Figure 3a shows the relationship between the substrate, the growth plane of which is the (111) plane, and the 〈011〉 directions of easy cleavage of the substrate.
Figures 3b and 3c are enlarged top plan views showing semiconductor laser devices obtained by a conventional method.

### DESCRIPTION OF THE PREFERRED EMBODIMENTS

This invention provides a method for the production of semiconductor devices by dividing a semiconductor wafer in which the semiconductor devices are formed on a semiconductor substrate as outlined in the claims. With the use of the striped grooves, the semiconductor wafer can readily be cleaved in a straight form at the portions other than the cleavage planes of a semiconductor crystal that is used for the substrate, resulting in semiconductor devices with a uniform rectangular shape.

### Examples

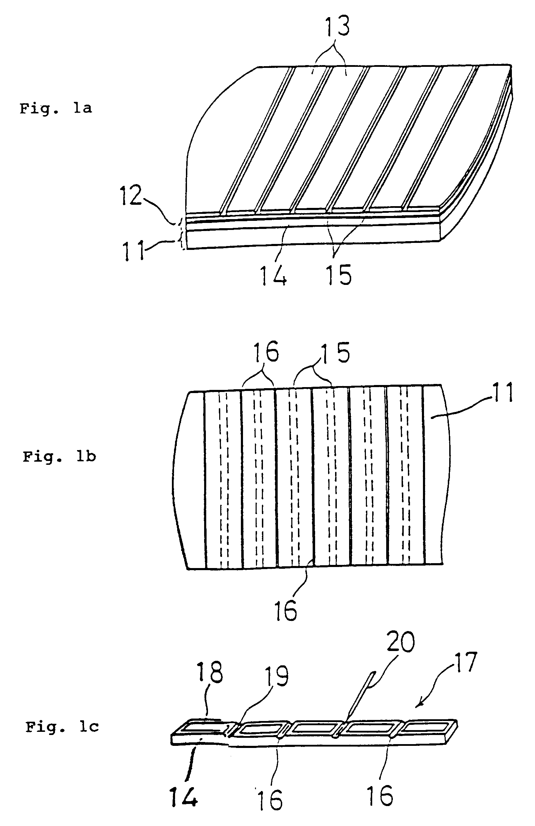

Figures 1a to 1c show the process for the production of semiconductor laser devices with the use of a semiconductor substrate, the growth plane of which is the (111)B plane, according to this invention.

First, as shown in Figure 1a, on the (111)B plane of an n-GaAs substrate **11**, a multi-layered structure **12** constituting a GRIN-SCH (graded-index separate confinement heterostructure) semiconductor laser with a single quantum well structure is grown by molecular beam epitaxy (MBE). Then, on the entire surface of the multi-layered structure **12**, a SiNx current blocking layer **13** is formed by plasma chemical vapor deposition (plasma CVD). In the current blocking layer **13**, striped channels **15** having a width of 50 µm are formed by photolithography and etching techniques, resulting in a striped structure within which current is confined. The striped channels **15** are parallel to each other and normal to the cleavage plane **14** of a GaAs crystal used for the substrate **11**. Then, the upper face of the current blocking layer **13** including the striped channels **15** is subjected to a vapor deposition treatment with a material of AuZn to form a p-sided electrode. Thereafter, the back face of the n-GaAs substrate is rubbed down, resulting in a semiconductor laser wafer having a thickness of 100 µm.

Next, as shown in Figure 1b, by photolithography and wet etching techniques, striped grooves **16** for dividing the wafer are formed in the back face of the n-GaAs substrate **11** of the semiconductor laser wafer obtained. The position of each of the striped grooves **16** is set to be parallel to and approximately in the middle of the two adjacent striped channels **15**. The etchant used for wet etching is a mixture of H₂SO₄, H₂O₂, and H₂O in the proportions of 1:2:50. The width and depth of the striped grooves **16** were 10 µm and 5 µm, respectively.

Then, on the back face of the n-GaAs substrate **11**, an n-sided electrode of AuGe is disposed by the vapor deposition method, followed by forming aluminum patterns **18** on the surface of the n-sided electrode. The aluminum patterns **18** serve as markers in dividing the wafer. The semiconductor laser wafer is then cleaved with the use of a set of cleavage planes **14** to form a laser resonator, resulting in small bars **17**. The cleavage planes **14** are normal to the 〈011〉 direction of the n-GaAs substrate **11**.

For each small bar **17**, as shown in Figure 1c, slight scratches **19** are formed on the bottom of the striped grooves **16** by means of a diamond scriber **20**. The direction of these scratches **19** is parallel to the striped grooves **16** and normal to the cleavage plane **14** of the small bar **17**. Thereafter, in the same manner as described above with reference to Figures 2b and 2c, a plurality of the small bars **17** are attached to the upper surface of an adhesive sheet, which is then stretched in longitudinal and transverse directions, resulting in separated semiconductor laser devices with a uniform rectangular shape.

By this process, high-quality semiconductor laser devices can be produced without incurring structural damage in their optical waveguides and without wafer dust adhering to the facets used for the emission of laser light.

Although in the above-mentioned example, the striped grooves **16** are formed on the back face of the substrate **11** by a wet etching technique using a sulfuric acid-containing etchant, a dry etching technique such as reactive ion beam etching (RIBE) and the like can also be used to form the striped grooves **16**. Moreover, the striped grooves **16** for dividing the small bar into the semiconductor devices may also be in the discrete form. The size of the striped grooves **16**, such as their depth, width, and length, can be conveniently determined depending upon the size of the semiconductor wafers, such as its thickness. The sequence of the steps of forming the striped grooves **16** on the back face of the substrate **11**; growing a multi-layered structure **12** on the substrate **11**; and providing the striped channels **15** on the upper face of the semiconductor wafer can be altered. If the back face of the substrate **11** is not rubbed down, after the striped grooves **16** are formed on this face, the multi-layered structure **12** may be grown on the upper face of the substrate **11**, followed by providing the striped channels **15** to complete the semiconductor wafer.

## Claims

1. A method for the production of semiconductor devices, said method comprising the steps of: - growing a multi-layered structure (12) comprising a plurality of epitaxial layers on a front face of a semiconductor substrate (11) made of zinc-blende-type semiconductor crystal, resulting in a semiconductor wafer in which semiconductor devices are formed on the substrate; forming striped grooves (16) on a back face of said substrate (11), each of said striped grooves being positioned between adjacent semiconductor devices; and dividing said substrate (11) along said striped grooves (16) to separate the semiconductor devices; said method being characterised in that, the growth plane of said substrate (11) is substantially the (111) plane; and in that said striped grooves (16) are formed in a direction which is not parallel to a plane of easy cleavage of said substrate.

2. A method for the production of semiconductor devices according to claim 1, wherein said striped grooves are formed by an etching technique.

3. A method for the production of semiconductor devices according to claim 1 or 2, wherein said multi-layered structure (12) comprises an optical waveguide to form a semiconductor laser device.

4. A method for the production of semiconductor devices according to claim 3, wherein said striped grooves (16) are formed parallel to said optical waveguide.

## Patentansprüche

1. Verfahren zur Herstellung von Halbleitereinrichtungen, wobei das Verfahren die Schritte aufweist: Aufwachsen einer Vielfachschicht-Struktur (12) mit einer Mehrzahl von epitaktischen Schichten auf der Vorderfläche eines Halbleitersubstrats (11), welches aus einem Halbleiterkristall vom Zinkblendetyp hergestellt ist, woraus ein Halbleiter-Wafer resultiert, in dem die Halbleitereinrichtungen auf dem Substrat gebildet sind; Bilden von Streifenrillen (16) auf der Rückfläche des Substrats (11), wobei jede der Streifenrillen zwischen benachbarten Halbleitereinrichtungen angeordnet ist; und Teilen des Substrats (11) entlang der Streifenrillen (16), um die Halbleitereinrichtungen voneinander zu trennen; wobei das Verfahren dadurch gekennzeichnet ist, die Wachstumsebene des Substrats (11) im wesentlichen die (111)-Ebene ist; und daß die Streifenrillen (16) in einer Richtung gebildet sind, die nicht parallel zu einer Ebene leichter Spaltbarkeit des Substrats ist.

2. Verfahren zur Herstellung von Halbleitereinrichtungen nach Anspruch 1, wobei die Streifenrillen durch eine Ätztechnik gebildet werden.

3. Verfahren zur Herstellung von Halbleitereinrichtungen nach Anspruch 1 oder 2, wobei die Vielfachschicht-Struktur (12) einen optischen Wellenleiter aufweist, um eine Halbleiterlasereinrichtung zu bilden.

4. Verfahren zur Herstellung von Halbleitereinrichtungen nach Anspruch 3, wobei die Streifenrillen (16) parallel zu dem optischen Wellenleiter gebildet sind.

## Revendications

1. Procédé pour la production de dispositifs à semi-conducteur, ledit procédé comprenant les phases :
- de constitution d'une structure multicouche (12) comprenant plusieurs couches épitaxiales sur une face frontale d'un substrat à semi-conducteur (11) fait de cristal semi-conducteur de type blende aboutissant à une plaquette à semi-conducteur dans laquelle des dispositifs à semi-conducteur sont formés sur le substrat ;
- de formation de rainures en bandes (16) sur la face arrière dudit substrat (11), chacune desdites rainures en bandes étant placée entre des dispositifs à semi-conducteur adjacents ; et
- de division dudit substrat (11) le long desdites rainures en bandes (16) pour séparer les dispositifs à semi-conducteur ;
ledit procédé étant caractérisé en ce que le plan de constitution dudit substrat (11) est sensiblement le plan (111) ; et en ce que lesdites rainures en bandes (16) sont formées dans une direction qui n'est pas parallèle à un plan de clivage privilégié dudit substrat.

2. Procédé pour la production de dispositifs à semi-conducteur selon la revendication 1, dans lequel lesdites rainures en bandes sont formées par une technique de gravure.

3. Procédé pour la production de dispositifs à semi-conducteur selon la revendication 1 ou 2, dans lequel ladite structure multicouche (12) comprend un guide d'ondes optiques pour réaliser un dispositif de laser à semi-conducteur.

4. Procédé pour la production de dispositifs à semi-conducteur selon la revendication 3, dans lequel lesdites rainures en bandes (16) sont formées parallèlement audit guide d'ondes optiques.
